# EUROPÄISCHE PATENTSCHRIFT

(11) **EP 0 357 993 B1**
(45) Veröffentlichungstag und Bekanntmachung des Hinweises auf die Patenterteilung: **17.11.1994**
(21) Anmeldenummer: 89114854.6
(22) Anmeldetag: 10.08.1989
(51) Int. Cl.: H03F 3/45

(54) **Differentieller Operationsverstärker mit Gleichtakt-Rückkoppelschaltung**
Differential operational amplifier with common mode signal feedback
Amplificateur differentiel opérationnel à circuit de contre-réaction pour signaux de mode commun

(30) Priorität: 05.09.1988 DE 3830150
(43) Veröffentlichungstag der Anmeldung: 14.03.1990
(73) Patentinhaber: SIEMENS AKTIENGESELLSCHAFT, 80333 München (DE)
(72) Erfinder: Koch, Rudolf, Dr., D-8025 Unterhaching (DE)

(56) Entgegenhaltungen:
- EP-A- 0 138 261
- IEEE JOURNAL OF SOLID-STATE CIRCUITS, Band SC-20, Nr. 6, Dezember 1985, Seiten 1122-1132, New York, US; R. CASTELLO et al.: "A high-performance micropower switched-capacitor filter"
- IEEE JOURNAL OF SOLID-STATE CIRCUITS, Band SC-17, Nr. 6, Dezember 1982, Seiten 1014-1023, New York, US; D. SENDEROWICZ et al.: "A family of differential NMOS analog circuits for a PCM codec filter chip"
- analog circuits for a PCM codec filter chip"

## Beschreibung

Die Erfindung betrifft eine Schaltungsanordnung nach dem Oberbegriff des Patentanspruchs 1.

Integrierte Schaltungen mit hohen Anforderungen an die Linerarität, die Unempfindlichkeit gegenüber Störungen auf den Versorgungsleitungen und/oder den Dynamikumfang verwenden häufig voll differentielle Operationsverstärker, d. h. Operationsverstärker mit einem Differenzeingang und einem Differenzausgang. Derartige Operationsverstärker können die gestellten Anforderungen auch noch bei einer unipolaren Versorgungsspannung von z. B. + 5V erfüllen. Weitere Vorteile liegen darin, daß voll differentielle Operationsverstärker zur Optimierung des Aussteuerbereiches unterschiedliche Gleichtakt-Eingangsgleichspannungen und -Ausgangsgleichspannungen aufweisen können, und daß sich mit ihnen Störungen von der Versorgungsseite unterdrücken lassen.

Obwohl bei voll differentiellen Operationsverstärkern die Differenzausgangsspannung von der Differenzeingangsspannung abhängt, muß allerdings der Gleichtakt-Gleichspannungsarbeitspunkt am Ausgang definiert werden. Insbesondere beim Einsatz eines derartigen Operationsverstärkers in Verbindung mit rein kapazitiver Kopplung, z. B. in einem Filter mit geschalteten Kapazitäten (Switched Capacitor Filter), muß der Gleichspannungsarbeitspunkt an den Ausgangsanschlüssen des Differenzausgangs durch eine Gleichtakt-Rückkoppelschaltung (Commom Mode Feedback, CMFB) eingestellt werden. Diese äußere Beschaltung des Operationsverstärkers dient gleichzeitig zur Unterdrückung von Gleichtaktsignalen am Ausgang. Der Gleichspannungsarbeitspunkt am Ausgang liegt zur Erreichung des maximalen Ausgangshubs vorzugsweise in der Mitte zwischen den beiden Potentialen der Versorgungsspannungsquelle.

Ein voll differentieller Operationsverstärker mit Gleichtakt-Rückkoppelschaltung (CMFB) ist aus der Vorveröffentlichung R. Castello, P. R. Gray " A 350µW Fifth-Order Low-Pass Switched Capacitor Filter", IEEE International Solid-State Circuits Conference 1985, p. 276 bekannt. Die dort beschriebene Gleichtakt-Rückkoppelschaltung enthält symmetrisch bezüglich jedes Ausgangsanschlusses des differentiellen Operationsverstärkers zwei mit ihren Ausgangskreisen in Reihe liegende Arbeitspunkttransistoren vom komplementärem Typ, die zwischen der Versorgungsspannungsquelle liegen und mit Hilfe eines Stromspiegels von einer Stromquelle gesteuert werden. Jeweils der Verbindungspunkt der Ausgangskreise der Arbeitspunkttransistoren ist an einen Ausgangsanschluß des differentiellen Operationsverstärkers und gleichzeitig an eine Klemme angeschlossen, die das Potential des Gleichtakt-Gleichspannungsarbeitspunktes führt.

Zwischen jedem Ausgangsanschluß des differentiellen Operationsverstärkers und dem Steueranschluß jeweils des n-leitenden Arbeitspunkttransistors ist eine Kapazität geschaltet, um einen Wechselspannungspfad für das Gleichtakt-Ausgangssignal zu erzeugen. Diese Koppelkapazitäten sind von der Klemme mit dem Gleichtakt-Gleichspannungspotential und dem den betreffenden Arbeitspunkttransistor steuernden Stromspiegeltransistor mit Hilfe hochohmiger Leitungselemente in geschalteter Kapazitätentechnik entkoppelt. Auf diese Weise wird ein uneingeschränkter Ausgangshub bei geringer Verlustleistung und hoher Linerarität bis knapp unterhalb der Versorgungsspannung erreicht. Die bekannte Gleichtakt-Rückkoppelschaltung kann posisitve Gleichtaktsignale schnell ausregeln, weil dann die n-leitenden Arbeitspunkttransistoren leitend werden. Die Geschwindigkeit zur Ausregelung negativer Gleichtaktsignale ist aber durch die als Stromquellen arbeitenden p-leitenden Arbeitspunkttransistoren begrenzt.

Der Erfindung liegt die Aufgabe zugrunde, die Ausregelgeschwindigkeit bei Gleichtaktsignalen negativer Polarität zu optimieren.

Diese Aufgabe wird bei einer Schaltungsanordnung der eingangs genannten Art erfindungsgemäß durch die Merkmale des kennzeichnenden Teils des Patentanspruchs 1 gelöst.

Die erfindungsgemäße Schaltungsanordnung besitzt den Vorteil, daß mit geringem Aufwand für die Gleichtakt-Rückkoppelschaltung der Gleichspannungsarbeitspunkt an den Ausgangsanschlüssen des differentiellen Operationsverstärkers auch bei schnellen Gleichtaktsignaländerungen in positiver oder negativer Richtung zuverlässig und schnell ausgeregelt sind.

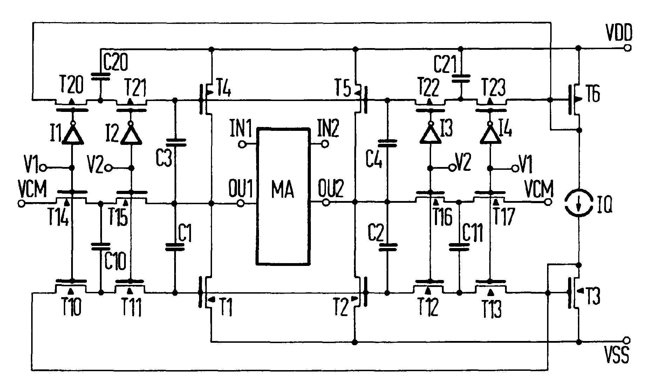

Die Erfindung wird im folgenden anhand eines in der einzigen Figur dargestellten Ausführungsbeispiels näher erläutert. Die Figur zeigt eine erfindungsgemäße Schaltungsanordnung in der Technik geschalteter Kapazitäten.

Gemäß der Figur ist der voll differentielle Operationsverstärker als Block MA dargestellt, wie er der in der Beschreibungseinleitung zitierten Vorveröffentlichung von R. Castello und P. R. Gray zu entnehmen ist. Der differentielle Operationsverstärker MA besitzt die beiden Differenzeingänge IN1 und IN2 sowie die beiden Differenzausgänge OU1 und OU2. Die Gleichtakt-Rückkoppelschaltung (CMFB) enthält zwei symmetrische Schaltungsteile, die jeweils einem Ausgangsanschluß OU1 des Operationsverstärkers MA zugeordnet sind. Die Beschreibung beschränkt sich deshalb auf die dem Ausgangsan schluß OU1 zugeordnete Teilschaltung unter Angabe der je weils entsprechenden Bauelemente für die dem anderen Ausgangsanschluß zugeordnete Teilschaltung.

Zwischen die Anschlüsse VDD und VSS zum Anschluß der Versorgungsspannungsquelle sind die in Serie geschalteten Ausgangskreise zweier komplementärer Arbeitspunkttransistoren T1 und T4 (T2 und T5) geschaltet. Entsprechend dem Leitungstyp werden die Arbeitspunkttransistoren paarweise (T1 und T2 sowie T4 und T5) mit Hilfe einer Stromspiegelanordnung aus den Transistoren T3 und T6 sowie der Stromquelle IQ gesteuert. T3, IQ und T6 sind in Serie zwischen die Klemmen VDD und VSS geschaltet. Jeweils die Drain- und Gate-Anschlüsse der Transistoren T3 bzw. T6 sind miteinander und mit den Steueranschlüssen der Transistoren T1 und T2 bzw. T4 und T5 verbunden. Die Steueranschlüsse von T1 und T2 sowie T4 und T5 sind weiterhin jeweils direkt miteinander verbunden.

Der Ausgangsanschluß OU1 (OU2) ist einerseits mit dem Verbindungspunkt der Ausgangskreise der Transistoren T1 und T4 (T2 und T5) und andererseits mit einer Referenzspannungsklemme VCM zum Anschluß des Gleichspannungs-Arbeitspunktpotentials verbunden. Weiterhin liegt zwischen dem Ausgangsanschluß OU1 (OU2) und einerseits dem Steueranschluß des Transistors T1 (T2) eine Kapazität C1 (C2) sowie andererseits dem Steueranschluß des Transistors T4 (T5) eine Kapazität C3 (C4).

Die Arbeitspunkttransistoren T1 und T4 (T2 und T5) regeln in Verbindung mit der Gleichspannung an der Klemme VCM den Gleichspannungsarbeitspunkt am Ausgang des differentiellen Operationsverstärkers MA. Bei schnellen Gleichtaktänderungen sorgen die Koppelkapazitäten C1 und C3 (C2 und C4) für eine Wechselspannungskopplung des Ausgangsanschlusses OU1 (OU2) und dem jeweiligen Steueranschluß des Arbeitspunkttransistors. Durch den Anschluß jeweils einer Koppelkapazität sowohl für den n- als auch für den p-leitenden Arbeitspunkttransistor wirkt diese Wechselspannungskopplung sowohl für positive als auch für negative Gleichtakt-Signaländerungen. Durch die Anordnung der Koppelkapazitäten wird die Stromergiebigkeit der Arbeitspunkttransistoren T1 und T4 (T2 und T5) in starkem Maße erhöht, so daß eine schnelle Ausregelung von Gleichtaktänderungen möglich ist.

Um die erfindungsgemäß vorgesehene Wirkung bei schnellen Gleichtaktänderungen in positiver bzw. negativer Richtung zu erzielen, ist es jedoch erforderlich, die Koppelkapazitäten C1 und C3 (C2 und C4) mit den Arbeitspunkttransistoren von der übrigen Gleichtakt-Rückkoppelschaltung zu entkoppeln, da sonst das kapazitiv auf die Steueranschlüsse der Arbeitspunkttransistoren gekoppelte Signal zu stark bedämpft würde. Zweckmäßigerweise wird deshalb jeder Anschluß einer Koppelkapazität C1 bzw. C3 (C2 bzw. C4) über Schalter mit der übrigen Gleichtakt-Rückkoppelschaltung verbunden. Für die zwei Anschlüsse von C1 sind dazu einerseits zwei mit ihren Ausgangskreisen in Reihe geschaltete Transistoren T10 und T11 (T12 und T13) vorgesehen, deren Ausgangskreise zwischen dem Verbindungspunkt von C1 und dem Steueranschluß von T1 (C2 und T2) sowie dem Drain/Gate-Anschluß des Transistors T3 liegen. Der andere Anschluß von C1 (C2), der gleichzeitig einen Anschluß von C3 (C4) bildet, ist über die beiden mit ihren Ausgangskreisen in Serie geschalteten Transistoren T14 und T15 (T16 und T17) mit der Klemme VCM verbunden. Der Verbindungspunkt von C3 und dem Steueranschluß von T4 (C4 und T5) schließlich liegt über den beiden mit ihren Ausgangskreisen in Reihe geschalteten Transistoren T20 und T21 (T22 und T23) am Drain-/Gate-Anschluß des Transistors T6. Zwischen den Verbindungspunkten der Ausgangskreise der Transistoren T10 und T11 (T12 und T13) und der Transistoren T14 und T15 (T16 und T17) liegt die Kapazität C10 (C11). Der Verbindungspunkt der Transistoren T20 und T21 (T22 und T23) ist über eine Kapazität C20 (C21) an die Klemme VDD angeschlossen.

Ein an einer Klemme V1 liegendes Taktsignal steuert die Transistoren T10 und T14 (T13 und T17) direkt und über einen Inverter I1 (I4) den Transistor T2O (T23). Ein an einer anderen Klemme V2 liegendes, gegenüber dem an der Klemme V1 liegenden Taktsignal vorzugsweise gegenphasiges anderes Taktsignal steuert die Transistoren T11 und T15 (T12 und T16) direkt und über einen Inverter I2 (I3) den Transistor T21 (T22).

Die beschriebene Entkoppelschaltung für jeweils einen Anschluß der Koppelkondensatoren C1 und C3 (C2 und C4) bildet hochohmige Leitungselemente in der Technik geschalteter Kondensatoren. Die gesteuerten Schalter dieser Leitungselemente werden dabei entsprechend der komplementären Typen der zu ihrer Realisierung verwendeten Transistoren invers gesteuert.

Selbstverständlich läßt sich die Erfindung in gleicher Weise auch bei einer Anordnung benutzen, die bezüglich der Leitfähigkeitstypen der Transistoren bzw. der Spannungsquelle komplementär bzw. invers aufgebaut ist.

## Patentansprüche

1. Schaltungsanordnung mit einem differentiellen Operationsverstärker (MA), der sowohl einen Differenzeingang (IN1; IN2) als auch einen Differenzausgang (OU1; OU2) aufweist und dessen ausgangsseitiger Gleichspannungsarbeitspunkt durch eine Gleichtakt-Rückkoppelschaltung einstellbar ist, indem die Ausgangsanschlüsse (OU1; OU2) des Differenzausgangs erstens mit einer eine Referenzspannung führenden Klemme (VCM) verbunden sind, zweitens angeschlossen sind an jeweils den Verbindungspunkt je zweier mit ihren Ausgangskreisen in Reihe geschalteter Arbeitspunkttransistoren (T1, T4; T2, T5) von komplementärem Leitungstyp, von denen jeweils gleiche Komplementärtypen parallel von einer Referenzstromquelle (T3, T6, IQ) gesteuert werden, sowie indem die Ausgangsanschlüsse drittens über je einen Koppelkondensator (C1; C2) mit dem Steueranschluß eines jeweils zugeordneten Arbeitspunkttransistors (T1; T2) eines Leitfähigkeitstyps verbunden sind, und bei der die Koppelkondensatoren (C1; C2) und die zugeordneten Arbeitspunkttransistoren (T1, T2; T4, T5) durch erste Leitungselemente in geschalteter Technik (T10 bis T13) von der übrigen Gleichtakt-Rückkoppelschaltung entkoppelt sind,
**dadurch gekennzeichnet**, daß jeweils ein weiterer Koppelkondensator (C3; C4) zwischen jedem Ausgangsanschluß des Differenzausgangs (OU1; OU2) und dem Steueranschluß des jeweils zugeordneten komplementären Arbeitspunkttransistors (T4; T5) unter Entkopplung beider Elemente von der übrigen Gleichtakt-Rückkoppelschaltung vorgesehen ist und daß die Entkopplung der weiteren Koppelkondensatoren (C3; C4) und der zugeordneten Arbeitspunkttransistoren von der übrigen Gleichtakt-Rückkoppelschaltung mit Hilfe von zweiten Leitungselementen (T20 bis T23, C20, C21) in geschalteter Kondensator-Technik erfolgt, deren Schalter (T20 bis T23) komplementär zu den Schaltern (T14 bis T17) entsprechender Leitungselemente zwischen den Ausgangsanschlüssen (OU1; OU2) des Differenzausgangs und der Referenzspannungsklemme (VCM) bzw. den Steueranschlüssen der ersten Leitungselemente in geschalteter Technik (T10 bis T13) und der Referenzstromquelle (T3, T6, IQ) sind, und invers dazu gesteuert werden.

## Claims

1. Circuit arrangement having a differential operational amplifier (MA) which has both a difference input (IN1; IN2) and a difference output (OU1; OU2) and whose output-side direct-voltage operating point can be adjusted by means of a common mode signal feedback, in that the output terminals (OU1; OU2) of the difference output are firstly connected to a terminal (VCM) which conducts a reference voltage, are secondly connected to in each case the connection point of in each case two operating point transistors (T1, T4; T2, T5) of the complementary conduction type which are connected with their output circuits, in series in each case the same complementary types of which being controlled in parallel by one reference current source (T3, T6, IQ), and in that thirdly, the output terminals are connected via in each case one coupling capacitor (C1; C2) to the control terminal of a respectively assigned operating point transistor (T1; T2) of a conduction type, and in which circuit arrangement the coupling capacitors (C1; C2) and the assigned operating point transistors (T1, T2; T4, T5) are isolated from the rest of the common mode signal feedback by first conduction elements in switched technology (T10 to T13), characterized in that in each case one further coupling capacitor (C3; C4) is provided between each output terminal of the difference output (OU1; OU2) and the control terminal of the respectively assigned complementary operating point transistor (T4; T5) with isolation of both elements from the rest of the common mode signal feedback, and in that the isolation of the further coupling capacitors (C3; C4) and of the assigned operating point transistor from the rest of the common mode signal feedback is carried out with the aid of second conduction elements (T20 to T23, C20, C21) in switched capacitor technology, the switches (T20 to T23) of which are complementary to the switches (T14 to T17) of corresponding conduction elements between the output terminals (OU1; OU2) of the difference output and of the reference voltage terminal (VCM) and the control terminals of the first conduction elements in switched. technology (T10 to T13) and of the reference current source (T3, T6, IQ), and are controlled inversely thereto.

## Revendications

1. Montage comportant un amplificateur opérationnel différentiel (MA), qui possède aussi bien une entrée de différence (IN1; IN2) qu'une sortie de différence (OU1; OU2) et dont le point de fonctionnement en tension continue, côté sortie, est réglable au moyen d'un circuit de réaction en mode commun, par le fait que les bornes de sortie (OU1; OU2) de la sortie de différence sont reliées, d'une part, à une borne (VCM) appliquant une tension de référence, et en second lieu respectivement au point de jonction de respectivement deux transistors (T1, T4; T2, T5) de type complémentaire, qui règle le point de fonctionnement et dont les circuits de sortie sont branchés en série et parmi lesquels respectivement des types complémentaires identiques sont commandés en parallèle par une source de courant de référence (T3, T6, IQ), ainsi que par le fait que les bornes de sortie sont reliées, en troisième lieu, par l'intermédiaire d'un condensateur de couplage respectif (C1; C2), à la borne de commande d'un transistor respectivement associé (T1; T2) de réglage du point de fonctionnement, possédant un type de conductivité, et dans lequel les condensateurs de couplage (C1; C2) et les transistors associés (T1, T2; T4, T5) de réglage du point de fonctionnement sont découplés du reste du circuit de réaction en mode commun, par des premiers éléments de ligne réalisés selon la technique commutée (T10 à T13),
caractérisé par le fait que respectivement un autre condensateur de couplage (C3; C4) est prévu entre chaque borne de sortie de la sortie de différence (OU1; OU2) et la borne de commande du transistor complémentaire respectivement associé (T4; T5) de réglage du point de fonctionnement, moyennant le découplage des deux éléments vis-à-vis du reste du circuit de réaction en mode commun, et que le découplage des autres condensateurs de couplage (C3; C4) et des transistors associés de réglage du point de fonctionnement s'effectue au moyen du reste du circuit de réaction en mode commun à l'aide de seconds éléments de ligne (T20 à T23, C20, C21) réalisés selon la technique des condensateurs commutés et dont les interrupteurs (T20 à T23) sont complémentaires des interrupteurs (T14 à T18) d'éléments de ligne correspondants situés entre les bornes de sortie (OU1; OU2) de la sortie de différence et la borne de tension de référence (VCM) ou les bornes de commande des premiers éléments de ligne réalisés selon la technique commutée (T10 à T13) et la source de tension de référence (T3, T6, IQ) et sont commandés d'une manière inverse.
